# EUROPÄISCHE PATENTSCHRIFT

(11) **EP 1 436 848 B1**
(45) Veröffentlichungstag und Bekanntmachung des Hinweises auf die Patenterteilung: **01.04.2015**
(21) Anmeldenummer: 02776689.8
(22) Anmeldetag: 20.09.2002
(51) Int. Cl.: H01L 41/187, C04B 35/493

(54) **PIEZOELEKTRISCHE KERAMISCHE WERKSTOFFE AUF DER BASIS VON BLEIZIRKONATTITANAT (PZT) MIT KRISTALLSTRUKTUR DES PEROWSKITS**
PIEZOELECTRIC CERAMIC MATERIALS BASED ON LEAD ZIRCONATE TITANATE (PZT) HAVING THE CRYSTAL STRUCTURE OF PEROVSKITE
MATERIAUX CERAMIQUES PIEZO-ELECTRIQUES A BASE DE TITANATE DE ZIRCONATE DE PLOMB (PZT) AYANT LA STRUCTURE CRISTALLINE DE LA PEROVSKITE

(30) Priorität: 29.09.2001 DE 10148378; 28.06.2002 DE 10229086
(43) Veröffentlichungstag der Anmeldung: 14.07.2004
(73) Patentinhaber: CeramTec GmbH, 73207 Plochingen (DE)
(72) Erfinder: HELKE, Günter, 91207 Lauf-Heuchling (DE)
(74) Vertreter: Uppena, Franz
(86) Internationale Anmeldenummer: PCT/DE2002/003528
(87) Internationale Veröffentlichungsnummer: WO 2003/029162

(56) Entgegenhaltungen:
- DE-A- 10 024 823
- US-A- 5 378 382
- PATENT ABSTRACTS OF JAPAN vol. 1996, no. 02, 29. Februar 1996 (1996-02-29) & JP 07 257924 A (TOYOTA CENTRAL RES & DEV LAB INC), 9. Oktober 1995 (1995-10-09)
- PATENT ABSTRACTS OF JAPAN vol. 1999, no. 04, 30. April 1999 (1999-04-30) & JP 11 001368 A (TDK CORP), 6. Januar 1999 (1999-01-06)

## Beschreibung

Die Erfindung betrifft Piezoelektrische keramische Werkstoffe auf der Basis von Bleizirkonattitanat (PZT) mit der Kristallstruktur des Perowskits mit der Formel A²+B⁴+O₃²⁻.

Piezokeramische Werkstoffe auf der Basis des Systems Pb(Zr,Ti)O₃, d.h. feste Lösungen von Bleizirkonat PbZrO₃ und Bleititanat PbTiO₃, zeichnen sich durch sehr gute dielektrische und elektromechanische Eigenschaften aus, die durch Modifikation der Zusammensetzung für unterschiedliche Anwendungen angepasst werden können.

Zur Erfüllung strenger Anforderungen bei speziellen Anwendungen wurden unterschiedliche Techniken zur Modifikation der Zusammensetzung entwickelt. Die Modifikation der Zusammensetzung ergibt sich durch teilweise Substitution von Ionen gleicher Wertigkeit an Pb-Plätzen und Zr/Ti-Plätzen und durch Dotierung mit Ionen abweichender Wertigkeit ebenso wie durch Substitution von Ionen-Komplexen.

Durch die Dotierung mit Ionen abweichender Wertigkeit werden in Abhängigkeit von lonenradius und Wertigkeit unterschiedliche Effekte erzielt. Durch "Donator-Ionen" wie La³⁺ und Nd³⁺ auf Pb²⁺-Plätzen oder Nb⁵⁺ auf (Zr/Ti)⁴⁺-Plätzen ergeben sich sogenannte "weiche" Piezokeramiken, die sich insbesondere durch eine große Dielektrizitätskonstante und eine hohe piezoelektrische Aktivität auszeichnen. Durch "Akzeptor-Ionen" wie K⁺ und Na⁺ auf Pb²⁺ -Plätzen oder Fe³⁺ auf (Zr/Ti)⁴⁺-Plätzen ergeben sich sogenannte "harte" Piezokeramiken, die sich insbesondere durch geringe dielektrische und mechanische Verluste, also eine hohe Güte, und hohe Koerzitivfeldstärke auszeichnen.

Die durch die jeweilige Ionenart erzeugten Ladungsdefizite werden durch Bildung von, einfach geladenen, Blei- beziehungsweise Sauerstoff-Fehlstellen kompensiert.

Eine gekoppelte Substitution heterovalenter Ionen kann für die Steuerung der Effekte von Donator- und Akzeptor-Ionen in Anspruch genommen werden. Dadurch wird es beispielsweise möglich, die durch Akzeptor-Dotierung hervorgerufenen Ladungs-Defizite mittels durch Donator-Dotierung entstehenden Ladungsüberschuss vollständig oder mindestens teilweise zu kompensieren. Durch die gekoppelte Substitution von Donator- und Akzeptor-Ionen ist es möglich, die Stabilität von Piezokeramiken auf der Basis von Bleizirkonattitanat bei Aufrechterhaltung der piezoelektrischen Aktivität und der hohen Dielektrizitätskonstante deutlich zu erhöhen, wie aus der DE 198 40 488 A1 bekannt ist.

Vielfältige Möglichkeiten der Modifikation von festen Lösungen des Systems Pb(Zr,Ti)O₃ ergeben sich mit der, teilweisen, Substitution von komplexen Verbindungen als valenzkompensierte Zusammensetzungen in Vielkomponenten-Systemen mit der allgemeinen Schreibweise PbTiO₃-PbZrO₃-ΣₙA'_{α}A"_{β}B'_{χ}B"_{δ}O₃. Bei Zugabe nur einer dieser komplexen Verbindungen zu dem binären System der festen Lösungen PbZrO₃-PbTiO₃[Pb(Zr,Ti)O₃] können "ternäre" feste Lösungen mit einer großen Variationsbreite der dielektrischen und elektromechanischen Eigenschaften gebildet werden. Zu solchen komplexen Verbindungen gehören auch solche mit der chemischen Formel A²⁺(B3⁺_{1/2} B⁵⁺_{1/2})O₃ mit A²⁺ = Pb²⁺, Sr²⁺ oder Ba²⁺. Mit dem Ionenpaar B^{3±}/B⁵⁺ ist auch eine gekoppelte Substitution von 3-wertigen Akzeptor-Ionen und 5-wertigen Donator-Ionen, beispielsweise von Fe³⁺/Nb⁵⁺ in einem Komplex Pb(Fe³⁺_{1/2} Nb⁵⁺_{1/2})O₃, an (Zr/Ti)⁴⁺ -Plätzen im System Pb(Zr,Ti)O₃ gegeben. In diesem Fall bewirkt die gekoppelte Substitution eine Ladungsneutralität, so dass Ladungsdefizite, die durch Bildung geladener Fehlstellen ausgeglichen werden müssen, nicht auftreten können. Trotzdem erfolgt mit der gekoppelten Substitution des Ionenpaares Fe³⁺/Nb⁵⁺ eine Änderung der dielektrischen und elektromechanischen Eigenschaften der in dieser Weise modifizierten PZT-Keramiken.

Es ist die Aufgabe der vorliegenden Erfindung, die piezoelektrischen keramischen Werkstoffe auf der Basis des Systems Pb(Zr,Ti)O₃ so zu modifizieren, dass ein hoher Level der piezoelektrischen Aktivität eingestellt wird.

Die Lösung der Aufgabe erfolgt mit Hilfe der kennzeichnenden Merkmale des ersten Anspruchs. Vorteilhafte Ausgestaltungen der Erfindung werden in den Unteransprüchen beansprucht.

Erfindungsgemäß sind Bleizirkonattitanat-Werkstoffe auf der Basis des Systems Pb(Zr,Ti)O₃ durch Substitution von heterovalenten Akzeptor- und Donator-Ionen an Zr/Ti-Plätzen modifiziert. Durch gekoppelte Substitution von heterovalenten Akzeptor- und Donator-Ionen an Zr/Ti-Plätzen, d.h. an B⁴⁺-Plätzen im Perowskit mit der allgemeinen Formulierung A²⁺B⁴⁺O₃²⁻, zur Bildung von nur partiell valenzkompensierten Zusammensetzungen des Systems PZT wird ein hoher Level der piezoelektrischen Aktivität eingestellt. Werkstoffe eines solchen Systems zeichnen sich durch eine hohe Curietemperatur und insbesondere auch durch eine gesteuerte Sinteraktivität aus, so dass unterschiedliche Formgebungs- und Sinterverfahren für piezokeramische Bauteile aus Werkstoffen dieses Systems zum Einsatz kommen können.

Im modifizierten System PZT der Erfindung kommt eine gekoppelte Substitution von Al³⁺-Akzeptor-Ionen und Nb⁵⁺-Donator-Ionen in Zusammensetzungen mit der allgemeinen Formulierung [Pb_{0,995}Sr_{0,02}][Al_{0,005}(ZrₓTi₁₋ₓ)_{0,975}Nb_{0,02}]0₃ in Betracht. Für den direkten Vergleich wurde die Zusammensetzung 0,98Pb(Zr _{0,52} Ti_{0,48})O₃ -0,02Sr(Al_{0,5} Nb_{0,5})O₃, eine valenzkompensierte gekoppelte Substitution von Akzeptor- und Donator-Ionen, herangezogen.

Die Eigenschaften der Zusammensetzung 0,98Pb(Zr_{0,52}Ti_{0,48})O₃-0,02Sr(Al_{0,5} Nb_{0,5})O₃ als Modellsubstanz mit dem hypothetischen Akzeptor-Donator-Komplex (AL_{0,5} Nb_{0,5})O₃ zeigen, dass es nicht möglich ist, durch Valenzkompensation bei Substitution des Ionen-Paares Al³⁺ Nb⁵⁺ im Ionenkomplex Sr(AL_{0,5} Nb_{0,5})O₃ Werkstoffe mit einer hohen piezoelektrischen Aktivität und gesteuerter Sinteraktivität herzustellen. Die dielektrischen und elektromechanischen Kenngrößen von Zusammensetzungen mit valenzkompensierter gekoppelter Substitution sind wesentlich geringer als die der Zusammensetzung mit partieller Valenzkompensation.

Die Sintertemperaturen der Piezokeramiken des Systems [Pb Sr_{0,02}][Al_{0,005}(Zrₓ Ti₁₋ₓ)_{0,995} Nb_{0,02}]0₃ liegen bei 1100 bis 1200°C und damit etwa 50 bis 70°C unterhalb der Sintertemperaturen von Piezokeramiken des Systems 0,98Pb (Zr_{0,52} Ti_{0,48})O₃-0,02Sr(AL_{0,5} Nb_{0,5})O₃.

Weitere Beispiele der Erfindung für eine gekoppelte Substitution von heterovalenten Akzeptor- und Donator-Ionen an Zr/Ti-Plätzen, d.h. B⁴⁺-Plätzen, sind Zusammensetzungen des Systems mit der allgemeinen Formulierung [Pb_{0,995}Sr_{0,02}][Fe_{0,005}(Zrₓ Ti₁₋ₓ)_{0,975} Nb_{0,02}]0₃.

Es folgen drei Vergleichsbeispiele für Zusammensetzungen sowie ein weiteres Beispiel für eine Vergleichszusammensetzung:

| | | |
|---|---|---|
| 1. | Piezoelektrischer keramischer Werkstoff der Zusammensetzung [PbSr_{0,02}][Al_{0,005}(Zr_{0,53}Ti_{0,47})_{0,995} Nb_{0,02}]0₃ | |
| | Formgebung: Trockenpressen | |
| | Sintertemperatur: 1200°C | |
| | Werkstoffdaten: | |
| | Dielektrizitätskonstante ε₃₃^{T}/ ε₀ | 1980 |
| | dielektrischer Verlustfaktor tan δ, 10⁻⁴ | 155 |
| | planarer elektromechanischer Kopplungsfaktor kₚ | 0,66 |
| | longitudinaler elektromechanischer Kopplungsfaktor k₃₃ | 0,74 |
| | Piezomodul d₃₃, 10⁻¹² C/N | 495 |
| | mechanischer Gütefaktor Q | 70 |
| | Curietemperatur, °C | 345 |
| 2. | Piezoelektrischer keramischer Werkstoff der Zusammensetzung [PbSr_{0,02}][Al_{0,005}Zr_{0,53}Ti_{0,47})_{0.995} Nb_{0,02}]0₃ | |
| | Formgebung: Foliengießen | |
| | Sintertemperatur: 1180°C | |
| | Werkstoffdaten: | |
| | Dielektrizitätskonstante ε₃₃^{T}/ ε₀ | 1860 |
| | dielektrischer Verlustfaktor tan δ, 10⁻⁴ | 160 |
| | planarer elektromechanischer Kopplungsfaktor kₚ | 0,64 |
| | Piezomodul d₃₃, 10⁻¹² C/N | 450 |
| | mechanischer Gütefaktor Q | 65 |
| | Curietemperatur, °C | 343 |
| 3. | Piezoelektrischer keramischer Werkstoff der Zusammensetzung [PbSr_{0,02}][Fe_{0,005}(Zr_{0,53}Ti_{0,47})_{0,995}Nb_{0,02}]0₃ | |
| | Formgebung: Trockenpressen | |
| | Sintertemperatur: 1200°C | |
| | Werkstoffdaten: | |
| | Dielektrizitätskonstante ε₃₃^{T}/ ε₀ | 2010 |
| | dielektrischer Verlustfaktor tan δ, 10⁻⁴ | 170 |
| | planarer elektromechanischer Kopplungsfaktor kₚ | 0,66 |
| | longitudinaler elektromechanischer Kopplungsfaktor k₃₃ | 0,73 |
| | Piezomodul d₃₃, 10⁻¹² C/N | 495 |
| | mechanischer Gütefaktor Q | 70 |
| | Curietemperatur, °C | 349 |
| 4. | Piezoelektrischer keramischer Werkstoff der Zusammensetzung 0,98Pb(Zr_{0,52}Ti_{0,48})O₃-0,02Sr(AL_{0,5}Nb_{0,5})O₃ als Modellsubstanz | |
| | Formgebung: Foliengießen | |
| | Sintertemperatur: 1250°C | |
| | Werkstoffdaten: | |
| | Dielektrizitätskonstante ε₃₃^{T}/ ε₀ | 975 |
| | dielektrischer Verlustfaktor tan δ, 10⁻⁴ | 45 |
| | planarer elektromechanischer Kopplungsfaktor kₚ | 0,36 |
| | Piezomodul d₃₃, 10⁻¹² C/N | 305 |
| | mechanischer Gütefaktor Q | 125 |
| | Curietemperatur, °C | 355 |

Die erfindungsgemäßen piezoelektrischen keramischen Werkstoffe, die nach der Mischoxid-Technik hergestellt sind, eignen sich insbesondere zur Herstellung von Folien, die im metallisierten und polarisierten Zustand in Sensoren eingesetzt werden. Aus den Folien lassen sich mehrlagige Aktoren, insbesondere mit monolithischen Strukturen, herstellen. Die Sintertemperatur liegt vorteilhaft im Bereich von 1100 bis 1200°C.

## Patentansprüche

1. Piezoelektrische keramische Werkstoffe, in essentieller Weise zusammengesetzt aus Bleizirkonattitanat (PZT) mit der Formel Pb²⁺(Zr⁴⁺, Ti⁴⁺)O₃²⁻ und der Kristallstruktur des Perowskits mit der Formel A²⁺B⁴⁺O₃²⁻, gekennzeichnet durch eine Substitution von partiell valenzkompensierenden Akzeptor- und Donator-Ionen-Paaren B³⁺_{0,005}/Nb⁵⁺_{0,02} zur Bildung von partiell valenzkompensierten Zusammensetzungen des Systems [Pb_{0,995}Sr_{0,02}][B³⁺_{0,005}(ZrₓTi₁₋ₓ)_{0,975}Nb⁵⁺_{0,02}]O₃, wobei x = 0,50 bis 0,55, so dass in den Zusammensetzungen eine gekoppelte Substitution von heterovalenten Akzeptor- und Donator-Ionen an Zr/Ti-Plätzen vorliegt, wobei B³⁺ mit Al³⁺- oder Fe³⁺-Ionen besetzt ist.

2. Piezoelektrische keramische Werkstoffe nach Anspruch 1, **dadurch gekennzeichnet, dass** ein Werkstoff des Systems einer Zusammensetzung von [Pb_{0,995}Sr_{0,02}] [Al_{0,005}(Zr_{0,53}Ti_{0,47})_{0,975}Nb_{0,02}]0₃ entspricht.

3. Piezoelektrische keramische Werkstoffe nach Anspruch 1, **dadurch gekennzeichnet, dass** ein Werkstoff des Systems einer Zusammensetzung von [Pb_{0,995}Sr_{0,02}] [Fe_{0,005}(Zr_{0,53}Ti_{0,47})_{0,975}Nb_{0,02}]0₃ entspricht.

4. Piezoelektrische keramische Werkstoffe nach einem der Ansprüche 1 bis 3, **dadurch gekennzeichnet, dass** die Werkstoffe nach der Mischoxid-Technik hergestellt sind.

5. Piezoelektrische keramische Werkstoffe nach einem der Ansprüche 1 bis 4, **dadurch gekennzeichnet, dass** die Werkstoffe bei Temperaturen im Bereich von 1100°C bis 1200°C gesintert sind.

6. Piezoelektrische keramische Werkstoffe nach einem der Ansprüche 1 bis 5, **dadurch gekennzeichnet, dass** die Werkstoffe zur Herstellung piezokeramischer Folien verwendbar sind.

7. Piezoelektrische keramische Werkstoffe nach Anspruch 6, **dadurch gekennzeichnet, dass** die Folien im metallisierten und polarisierten Zustand in Sensoren einsetzbar sind.

8. Piezoelektrische keramische Werkstoffe nach Anspruch 6 oder 7, **dadurch gekennzeichnet, dass** die Folien in mehrlagigen Strukturen in Aktoren einsetzbar sind.

9. Piezoelektrische keramische Werkstoffe nach Anspruch 8, **dadurch gekennzeichnet, dass** die Strukturen monolithisch sind.

## Claims

1. Piezoelectric ceramic materials, composed essentially of lead zirconate titanate (PZT) having the formula Pb²⁺(Zr⁴⁺, Ti⁴⁺)O₃²⁻ and having the crystal structure of perovskite with the formula A²⁺B⁴⁺O₃²⁻, **characterised by** a substitution of partially valency-compensating acceptor and donor ion-pairs B³⁺_{0.005}/Nb⁵⁺_{0.02} for the purpose of forming partially valency-compensated compositions of the [Pb_{0.995}Sr_{0.02}] [B³⁺_{0.005}(ZrₓTi₁₋ₓ)_{0.975}Nb⁵⁺_{0.02}]O₃ system, where x = 0.50 to 0.55, so that in the compositions a coupled substitution of heterovalent acceptor and donor ions is present at Zr/Ti sites, where B³⁺ is occupied by Al³⁺ or Fe³⁺ ions.

2. Piezoelectric ceramic materials according to claim 1, **characterised in that** a material pertaining to the system corresponds to a composition of [Pb_{0.995}Sr_{0.02}] [Al_{0.005}(Zr_{0.53}Ti_{0.47})_{0.975}Nb_{0.02}]O₃.

3. Piezoelectric ceramic materials according to claim 1, **characterised in that** a material pertaining to the system corresponds to a composition of [Pb_{0.995}Sr_{0.02}] [Fe_{0.005}(Zr_{0.53}Ti_{0.47})_{0.975}Nb_{0.02}]O₃.

4. Piezoelectric ceramic materials according to one of claims 1 to 3, **characterised in that** the materials are produced by mixed-oxide technology.

5. Piezoelectric ceramic materials according to one of claims 1 to 4, **characterised in that** the materials are sintered at temperatures within the range from 1100 °C to 1200 °C.

6. Piezoelectric ceramic materials according to one of claims 1 to 5, **characterised in that** the materials can be used for producing piezoceramic films.

7. Piezoelectric ceramic materials according to claim 6, **characterised in that** the films can be employed in the metallised and polarised state in sensors.

8. Piezoelectric ceramic materials according to claim 6 or 7, **characterised in that** the films can be employed in multilayer structures in actuators.

9. Piezoelectric ceramic materials according to claim 8, **characterised in that** the structures are monolithic.

## Revendications

1. Matériaux céramiques piézoélectriques, constitués de manière essentielle de zirconate-titanate de plomb (PZT) avec la formule Pb²⁺(Zr⁴⁺, Ti⁴⁺)O₃²⁻ et présentant la structure cristalline de la pérovskite avec la formule A²⁺B⁴⁺O₃²⁻, **caractérisés par** une substitution de paires d'ions accepteurs et donateurs B³⁺_{0,005}/Nb⁵⁺_{0,02} partiellement compensateurs de valence, pour former des compositions, compensées partiellement en valence, du système [Pb_{0,995}Sr_{0,02}][B³⁺_{0,005}(ZrₓTi₁₋ₓ)_{0,975}Nb⁵⁺_{0,02}]O₃, où x = 0,50 à 0,55, de sorte que dans les compositions, il y a une substitution couplée d'ions accepteurs et donateurs hétérovalents à des emplacements Zr/Ti, B³⁺ étant occupé par des ions Al³⁺ ou Fe³⁺.

2. Matériaux céramiques piézoélectriques selon la revendication 1, **caractérisés en ce qu'**un matériau du système correspond à une composition de [Pb_{0,995}Sr_{0,02}][Al_{0,005}(Zr_{0;53}Ti_{0,47})_{0,975}Nb_{0,02}]O₃.

3. Matériaux céramiques piézoélectriques selon la revendication 1, **caractérisés en ce qu'**un matériau du système correspond à une composition de [Pb_{0,995}Sr_{0,02}][Fe_{0,005}(Zr_{0;53}Ti_{0,47})_{0,975}Nb_{0,02}]O₃.

4. Matériaux céramiques piézoélectriques selon l'une des revendications 1 à 3, **caractérisés en ce que** les matériaux sont fabriqués selon la technique des oxydes mixtes.

5. Matériaux céramiques piézoélectriques selon l'une des revendications 1 à 4, **caractérisés en ce que** les matériaux sont frittés à des températures situées dans la plage allant de 1 100 °C à 1 200 °C.

6. Matériaux céramiques piézoélectriques selon l'une des revendications 1 à 5, **caractérisés en ce que** les matériaux peuvent être utilisés pour fabriquer des films piézocéramiques.

7. Matériaux céramiques piézoélectriques selon la revendication 6, **caractérisés en ce que** les films peuvent être utilisés à l'état métallisé et polarisé dans des capteurs.

8. Matériaux céramiques piézoélectriques selon la revendication 6 ou 7, **caractérisés en ce que** les films peuvent être utilisés dans des structures à plusieurs couches dans des actionneurs.

9. Matériaux céramiques piézoélectriques selon la revendication 8, **caractérisés en ce que** les structures sont monolithiques.
